# EUROPEAN PATENT APPLICATION

(11) **EP 2 293 321 A1**
(43) Date of publication of application: **09.03.2011**
(21) Application number: 09169773.0
(22) Date of filing: 08.09.2009
(51) Int. Cl.: H01L 21/00

(54) **Mechanical modularity chambers**

(71) Applicant: Applied Materials, Inc., Santa Clara, CA 95054 (US)
(72) Inventor: Schaefer, Michael, 63674, Altenstadt (DE); Geiss, Andreas, 63452, Hanau (DE)
(74) Representative: Zimmermann, Gerd Heinrich

(57) **Abstract**

The present invention relates to a seal carrier plate 101 and a system 301 of interchangeable chambers. A seal carrier plate is provided, wherein the seal carrier plate is adapted for being located between a first chamber 108a and a second chamber 108b and adapted for sealing the first chamber with respect to the second chamber from the environment, and wherein the seal carrier plate comprises an opening 105 for transferring of substrates 303 from the first chamber to the second chamber. Further, a system 301 of interchangeable chambers is provided, wherein the chambers 108 are adapted for accommodating a seal carrier plate 101 on at least one side of the chamber with an opening 105.

## Description

### TECHNICAL FIELD OF THE INVENTION

Embodiments of the present invention relate to an apparatus for sealing one chamber in relation to an adjacent chamber from the environment. They further relate to a system of chambers. Particularly, they relate to a seal carrier plate for sealing one chamber in relation to an adjacent chamber from the environment and to an in-line system of chambers, to a system of interchangeable chambers in a processing line and a use of a seal carrier plate.

### BACKGROUND OF THE INVENTION

Processing lines for substrates in a factory can consist of several chambers. The two or more chambers are aligned next to each other along the production line. The several chambers can be chambers for passing the substrates in and out of the production line, chambers for treating the substrates e.g. heating the substrate, depositing material on a substrate, etching a substrate, thermal processing of a substrate or the like, etc. Thereby, the chambers are often under vacuum or under a controlled atmosphere.

Production lines with several chambers are often used for the treatment of glass substrates or other substrates which might be transferred through the production line with or without a carrier. The substrates can be heated and coated with one or several materials in the several chambers along the production line.

The substrates to be processed travel along the production line through an opening from one chamber to the next. The maintenance of the production line and its component is very important. Each interruption of the production line is costly, because the whole processing line must be stopped and throughput is thereby reduced. So, it is desirable to keep the time of any maintenance interruption as low as possible. Additionally, storing of spare parts and the option to run different processes in one production line are becoming more and more important. Thus, the flexibility of a production line is a further aspect to be considered.

### SUMMARY OF THE INVENTION

In light of the above, embodiments are directed to a seal carrier plate according to independent claim 1, to a system of interchangeable chambers in a processing line according to independent claim 8, the use of a seal carrier plate according to independent claim 11 and a factory according to claim 12.

According to one embodiment, a seal carrier plate is provided. The seal carier plate is adapted for being located between a first chamber and a second chamber, the seal carrier plate includes: a plate shaped member having a first side and a second side; an opening within the plate shaped member adapted for transferring substrates from the first chamber to the second chamber, a first seal carrying means on the first side and a second seal carrying means on the second side; and a plurality of holes adapted for having a plurality of fixation elements connecting the first and the second chamber passed therethrough.

According to another embodiment, a system of interchangeable chambers in a processing line is provided. The system includes a multitude of chambers, wherein the chambers have at least one opening and have flat surfaces as flanges on at least one side with an opening, wherein the flanges are adapted for mounting a seal carrier plate on at least one side with an opening between a first chamber and a second chamber, wherein the seal carrier plate is adapted for sealing the first chamber with respect to the second chamber from the environment.

According to yet another embodiment, a processing line of interchangeable chambers in a processing line having a plurality of chambers is provided. The chambers include at least one opening; a flange or flanges on at least the side or the sides with the at least one opening; at least one flat surface at each of the flanges, wherein the flanges are adapted for mounting a seal carrier plate between a first chamber and a second chamber, the seal carrier plate having a flat surface and seal carrying means; and wherein the seal carrier plate is adapted for sealing the first chamber with respect to the second chamber from the environment.

According to a further embodiment, the use of a seal carrier plate in between a first chamber and a second chamber in a multitude of chambers in a processing line for sealing the first chamber with respect to the second chamber from the environment according embodiments described herein is provided.

Furthermore, according to another embodiment, a factory is provided. The factory includes a system of interchangeable chambers in a processing line according to embodiments described herein and at least one seal carrier plate according to embodiments described herein.

Further effects, features, aspects and details that can be combined with the above embodiments are evident from the dependent claims, the description and the drawings.

Embodiments are also directed to apparatuses for carrying out the disclosed methods and including apparatus parts for performing the described method steps. These method steps may be performed by way of hardware components, a computer programmed by appropriate software, by any combination of the two or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWING

So that the manner in which the above recited features of the present invention can be understood in detail, a more particular description of the invention, briefly summarized above, may be had by reference to embodiments. The accompanying drawings relate to embodiments of the invention and are described in the following:
- Figure 1A: shows a front view of the seal carrier plate according to embodiments described herein;
- Figure 1B: shows a back view of the seal carrier plate according to embodiments described herein;
- Figure 1C: illustrates a cross-section of embodiments of a first and a second chamber and a seal carrier plate sealing the first chamber in relation to the second chamber from the environment;
- Figure 2: shows a side view of a chamber according to embodiments described herein;
- Figure 3: shows a system of a multitude of interchangeable chambers in a processing line according to embodiments described herein;
- Figure 4: illustrates embodiments of the seal carrier plate with a conduit opening.

### DETAILED DESCRIPTION OF THE DRAWINGS

Reference will now be made in detail to the various embodiments of the invention, one or more examples of which are illustrated in the figures. Within the following description of the drawings, the same reference numbers refer to the same components. Generally, only the differences with respect to the individual embodiments are described. Each example is provided by way of explanation of the invention and is not meant as a limitation of the invention. For example, features illustrated or described as part of one embodiment can be used on or in conjunction with other embodiments to yield yet a further embodiment. It is intended that the present invention includes such modifications and variations.

As will be understood herein, the processing direction is defined as the direction the substrates take when they are transferred from one chamber to the next chamber in a system of several chambers which are aligned in-line.

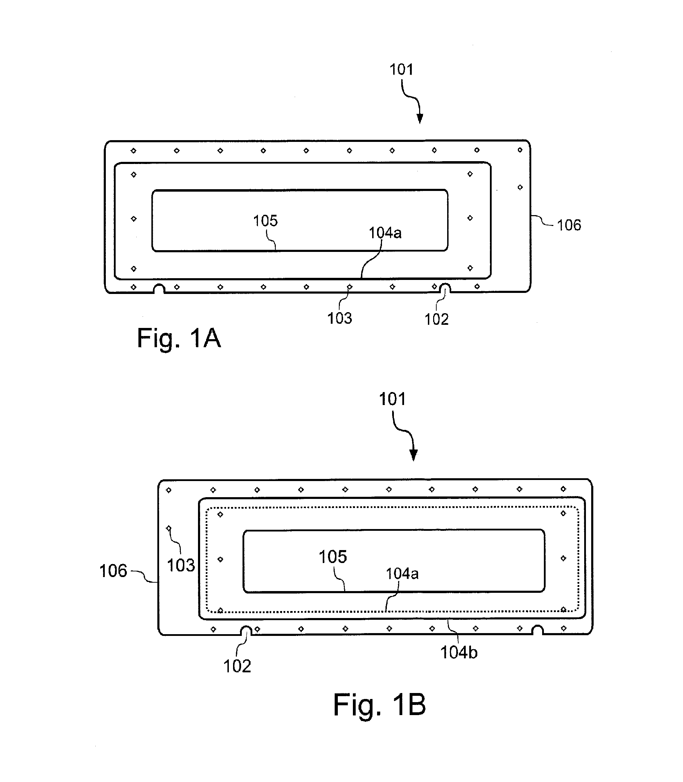

FIG. 1A illustrates a front view of embodiments of a seal carrier plate. FIG. 1B shows a back view of embodiments of a seal carrier plate. The seal carrier plate 101 is adapted for being located between a first chamber and a second chamber and adapted for sealing the first chamber with respect to the second chamber from the environment. The seal carrier plate has a plate member 106 with a first side and a second side and one opening 105 within the plate shaped member for transferring of substrates from the first chamber to the second chamber. Typically, the seal carrier plate includes a first seal carrying means 104a on the first side (see, e.g., FIG. 1A) and a second seal carrying means 104b on the second side (see e.g., FIG. 1B). Openings or holes 103 are provided for connecting adjacent chambers in a production line such that the seal carrier plate 101 is provided between a first and a second chamber with a sealing function. Further, two or more recesses 102 can be provided according to some embodiments described herein. A recess can be used for e.g. supporting the seal carrier plate between two chambers during mounting of the production line. The recesses may have further advantages, which are described in more detail below.

According to some embodiments, which can be combined with other embodiments described herein, the chambers and, thus, the production line is adapted for processing large area substrates. Accordingly, the opening 105 can have a width to allow at least GEN5 substrates to be transported through the opening from the first to the second chamber. According to yet typical embodiments, even substrate sizes GEN 6, GEN 7, GEN 8, GEN 9 and GEN 10 being 1100 mm * 1250 mm, 1500 mm * 1800 mm, 1870 mm * 2200 mm, 2160 mm * 2460 mm, 2400 mm * 2800 mm and 2880 mm * 3080 mm, respectively, may be used. Thus, the width of the opening along a dimension perpendicular to the processing direction can be between 1000 mm and 3100 mm. Typically, the height of the opening for the substrates to be transferred is between 4 cm and 60 cm.

According to typical embodiments, the seal carrying means of the seal carrier plate are grooves. The form of the seal carrying means around the opening can be a rectangle with rounded corners. Typically, a carrier plate 101 may have a first seal 104a on the first side and a second seal 104b on the second side of the plate member 106. In some embodiments of the seal carrier plate, the seal carrier plate may have two or more seals on each of two sides. For example, it has at least one additional seal around the opening for the substrates. Thereby, one, two, three or more seals around the opening can be provided according to different embodiments described herein. Typically, the seal is an O-ring type seal.

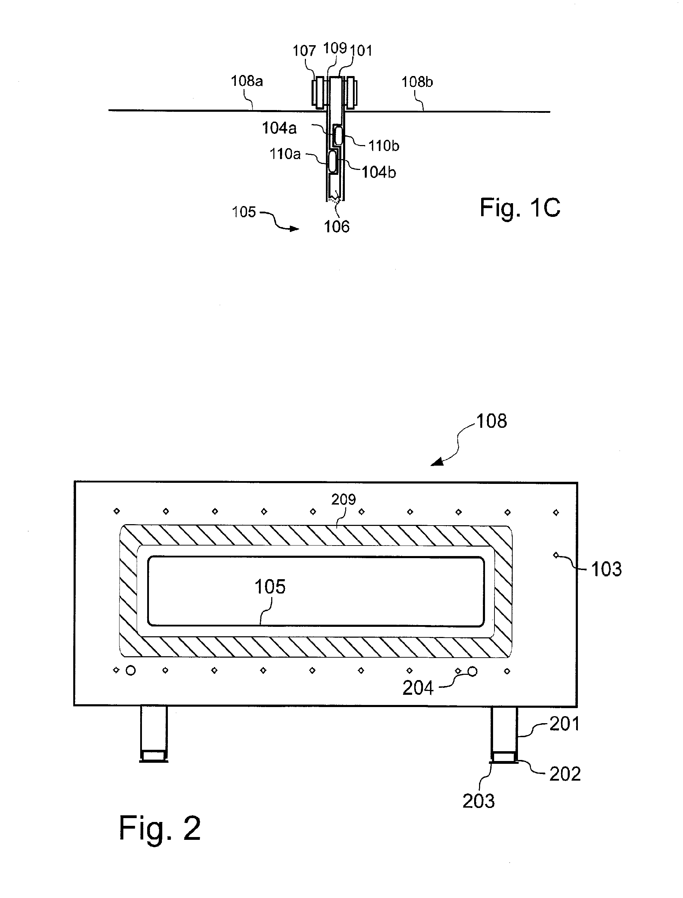

FIG. 1C shows a cross-section of embodiments of a seal carrier plate 101 in a mounted position between a first chamber 108a and a second chamber 108b. The seal carrier plate 101 seals the first chamber in relation to the second chamber from the environment. It further shows one seal 110a attached to the first side of the seal carrier plate and a second seal 110b attached to the second side of the seal carrier plate. As illustrated with respect to FIG. 1C, the seals are provided in the seal carrier means, for example grooves, on the respective side of the plate shaped member.

Generally, it is possible to have a first seal carrier means and a second seal carrying means on corresponding opposing positions on the first and the second side, respectively. However, particularly, if the seal carrying means is provided as a groove, the thickness of the seal carrier plate can be reduced if the first groove on the first side of the plate shaped member and the second groove on the second side of the plate shaped member are provided to offset each other. The thickness, i.e., the space required between two adjacent chambers might be relevant for a plurality of reasons. On the one hand, depending on the size of the production line, the footprint of the production line might be reduced, especially if a plurality of chambers might be arranged in one row. On the other hand, a reduced size of the sealing plate can reduce the required effort during maintenance of the production line. Thus, according to some typical embodiments, the seal on the first side of the seal carrier plate and the seal on the second seal carrier plate are offset from each other. By having the seals on the opposite sides to offset each other, the width of the seal carrier plate with one seal on each side can be decreased. This saves space and makes the removal/insertion of the seal carrier plate in between the chambers easier.

In embodiments of the seal carrier plate, the seal carrying means on one side of the seal carrier plate is wider than the seal carrying means on the other side of the seal carrier plate. Typically, the seal on the first side circumscribes a larger area than the seal on the second side. In embodiments, the area circumscribed by the seal on the first side of the seal carrier plate is larger than the area circumscribed by the seal on the second side of the seal carrier plate. Typically, the area circumscribed by the smaller seal is at least 1000 cm^{2.} The typical position of the groove 104a on the first side of the seal carrier plate is indicated by the dotted line in FIG. 1B.

In some embodiments described herein, the seal carrier plate is made of aluminium. The seal carrier plate can have a width, i.e. a thickness of 0.5 cm to 3 cm.

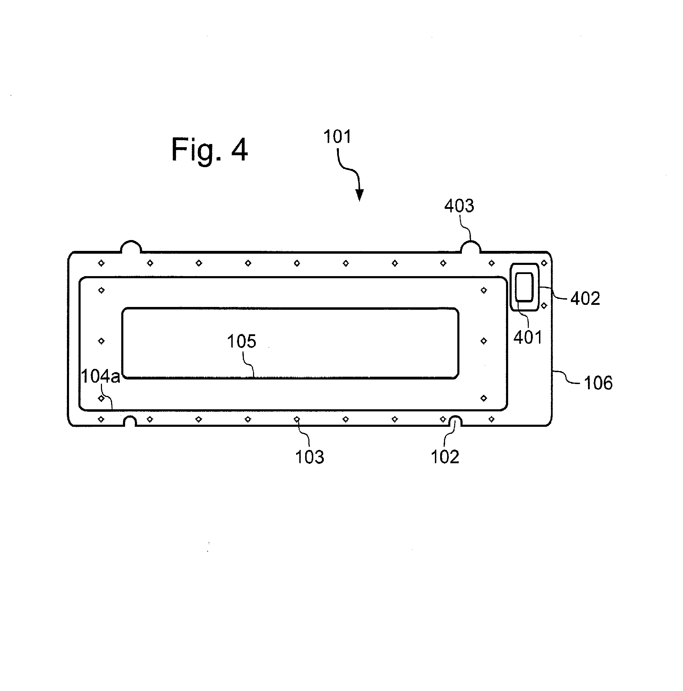

According to some embodiments, which can be combined with other embodiments described herein, the chambers 108a, 108b or essentially all chambers in a processing line have a predefined or similar flange design. Typically, the flanges 109 of the chambers have a flat surface including one or more openings, for example for trespassing of substrates, for vacuum exchange, for exchange of process gases or the like. This is for example illustrated in Fig. 4. The flat surface allows for having a standard flange design for both sides of the chamber and/or for each of the chambers in a processing line. Accordingly, it is possible to assemble the chambers in an arbitrary order and to have the seal carrier plate, which is e.g., a relatively small part as compared to the chamber, carry all sealing means which are desired for connecting the chambers to each other. Thus, an increased flexibility and easier maintenance can be achieved. Thus, according to some embodiments described herein, a standard platform for chambers in a production line can be provided. For example, a standard flange design for both sides of a chamber can be provided, which allows for an arbitrary orientation of the chamber in the line. The standard flange design allows further for an arbitrary order of the chambers within the production line.

As shown in FIG. 1C, holes for chamber connection means 107 can be provided. Thereby, the chamber connection means and the holes are mutually adapted such that the connection means 107 pass through the holes. In embodiments, chamber connection means are connecting the first chamber with the seal carrier plate and with the second chamber. Typically, the seal carrier plate includes a plurality of holes 103 adapted for having the plurality of chamber connection means of the first and the second chamber passed there through.

In embodiments, chamber connection means pass through the holes in the flange of the first chamber, the holes in the seal carrier plate and the holes in the flange of the second chamber. In embodiments, the holes for chamber connection means are outside of the seals around the opening 105. However, the holes for the chamber connection means can also be inside of the seals of the seal carrier plate.

FIG. 2 illustrates a flat sealing surface 210, which can be used for pressing a sealing member like an O-ring to the surface. Further, according to some embodiments described herein, the chamber support feet 201 may include rollers 202, that can be used to move the chamber on a flat plate 203. Thereby, the flat plate provides guidance for the rollers 202.

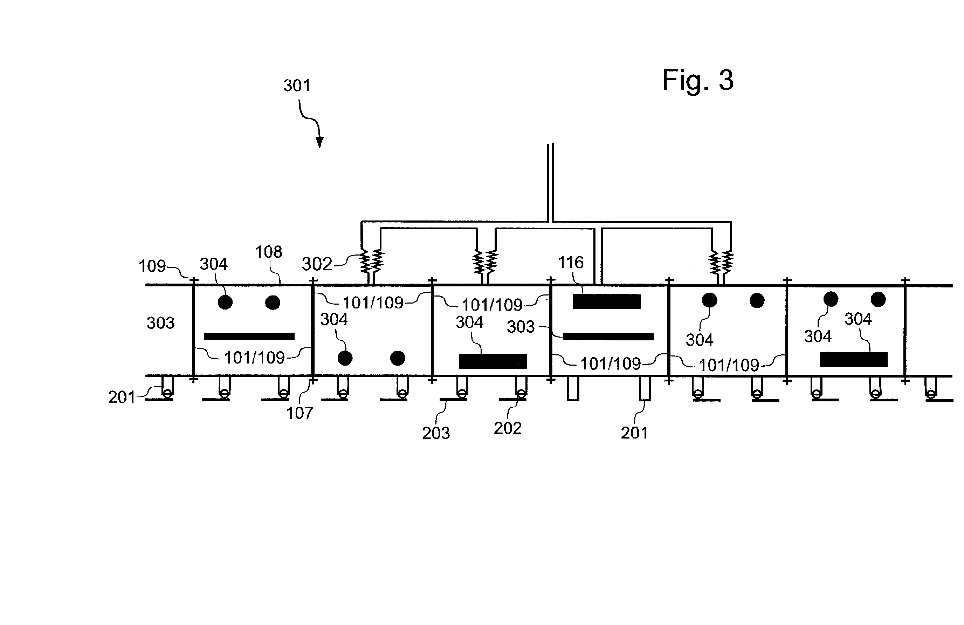

FIG. 3 illustrates embodiments of a system 301 of a multitude of interchangeable chambers in a processing line. The multitude of chambers is typically aligned in-line. In embodiments, the chambers 108 are adapted for accommodating such a seal carrier plate on at least one side, typically both sides of a chamber, with an opening.

According to embodiments described herein, as e.g. shown in FIG. 3, a plurality of chambers, e.g. five or more chambers 108 are provided. Each chamber has a flange 109 for connecting one chamber to an adjacent chamber. The chambers and the seal carrier plates disposed there between are connected by connection elements 107 such as screws or the like. As indicated by the reference numerals 101/109 in FIG. 3, between each of corresponding adjacent chambers, a seal carrier plate 101 is disposed. The chambers are provided on feet 201, which may be used to align the chambers with respect to each other. The chambers or at least some of the chambers, particularly off-center chambers, are provided with rollers 202 being positioned on a support surface 203 such that the chambers can be moved parallel to the processing direction.

According to yet further embodiments, supply lines 302 and/or connects for transferring and receiving control signals are connected to the chambers. Within the chambers substrate 303 can be transported along the processing direction and to be exposed to different treatment devices 304.

Typically, the feet of the center or near-center chamber of the system are fixedly mounted to the floor. The center chamber is the chamber which is located in the middle of the multitude of chambers which are aligned in-line, if the number of chambers is even. The near-center chamber is one of the two chambers which is located closest to the middle of the multitude of chambers which are aligned in-line, if the number of chambers is odd. The definition of the center or near-center chamber is illustrated by the following examples: if the system consists of nine chambers, the chamber which has four chambers located on its one side and four chambers located on its other side is the center chamber; if the system consists of eight chambers, one of the two chambers which has three chambers located on its one side and four chambers located on its other side is the near-center chamber. In embodiments, all other chambers but the center or near-center chamber are located on feet which are based on rollers and are, thus, movable.

Accordingly, embodiments described herein, can provide for an easy exchange of the chamber sealing. Thereby, the chambers can be moved to a have a distance from each other which is very small and the seal carried plate can be pulled out of the gap between the chambers. According to typical embodiments, it might be sufficient to provide a gap between the chambers of a few millimeters to a few centimeters, such as 20 mm to 100 mm, or typically to provide a gap of with a dimension of 10 mm to 20 mm more than the thickness of the seal carried plate. Based on the fact the sealing member like an O-ring is provided in the seal carrying means in the seal carrying plate, the seal carrying plate including the seal can be removed for maintenance or exchange of the seal.

Typically, the supply lines 302 of the chambers, i.e. for gas, electricity and the like, are attached flexibly, so the supply lines do not need to be unfastened when the chambers are moved. Accordingly the supply lines do not need to be unfastened when the chambers are moved for the removal/exchange of one or several seal carrier plates. In embodiments, the chambers can be moved between 2 cm and 5 cm in or against the processing direction without the need to unfasten the supply lines.

Typically, the chambers have a length of between 2 m and 7 m. This may result in a length of a processing line having for example 7 to 15 chambers of about 35 to 75 m. Thus, the aspect of easy maintenance and a reduced or even eliminated need to significantly move the chambers for maintenance of a seal can increase the throughput of a processing line based on improved availability of the facility. Substrates 303, which are processed in the processing line, are transferred from one chamber to the next chamber along the processing line. The substrates can be transported on a carrier or without a carried depending on the kind of substrate. Typically, the several chambers can be chambers for passing the substrates in and out of the production line (load lock), chambers for transferring the substrates from the load lock to the processing chambers, chambers for heating the substrates, and chambers for processing the substrates with PVD, CVD, PECVD processes, etching processes, heat treatment processes or the like.

The different treatment devices 304 in the several chambers are indicated in FIG. 3. In embodiments, the treatment of the substrate in the different chambers is done under vacuum or under a controlled atmosphere, i.e. a gas or a mixture of processing and carrier gases Therefore, in embodiments the chambers and the connection between the chambers have to be airtight. In embodiments with the chambers under a vacuum or a controlled atmosphere, the chambers have to be sealed in respect to the adjacent chamber or chambers from the environment. Otherwise the vacuum or controlled atmosphere could deteriorate.

The substrates, which are processed and transferred from one chamber to the next chamber, can be glass substrates like they are used in solar panels, e.g. GEN 5, GEN 6, GEN 7, GEN 8, GEN 9 or GEN 10 substrates. Typically, the glass substrates might be heated to high temperatures in one or several of the chambers. Therefore, in embodiments the seal and the seal carrier plate have to withstand high temperatures. Typically, the seal and the seal carrier plate can withstand elevated temperatures of up to 50°C to 150 °C.

Sealing large chambers and/or one chamber in respect to an adjacent chamber from the environment is difficult because of the large area which has to be sealed. Especially since the chambers and the openings between the chambers can be large. Typically, the pressure in the chambers in the processing line while operating is between 100 mbar and 3 * 10⁻⁶ mbar, more typically around 10⁻³ mbar. Thus, for some embodiments, which can be combined with other embodiments described herein, the seal carrier plate with a seal for sealing one chamber in respect to an adjacent chamber from the environment is adapted for a difference of pressure of up to 10⁹ mbar.

Commonly, a seal sealing one chamber in respect to an adjacent chamber from the environment has been embedded in a flange of a chamber. This leads to an asymmetry of the chamber. Such chambers situated in-line along a processing line could not be interchanged and/or rotated. Also, for connecting two chambers, one chamber with an embedded seal and one chamber without an embedded seal were needed. So, there were at least two types of chambers and/or flange designs: chambers with an embedded seal in the flange and chambers without an embedded seal in the flange.

Having a system of a multitude of chambers in a processing line, where the seal is not embedded in the flange of the chamber may result in the following. The chambers in a processing line can be interchanged and/or rotated, since the chambers are symmetric. Only one type of chamber and/or flange design is needed. This reduces the manufacturing costs of each chamber. The exchange of a seal carrier plate with the attached seals can require a reduced need for moving chambers with respect to each other and, thus, typically takes less time than the exchange of a seal which is embedded in a flange. Thus, the downtime of the system of chambers can be reduced and the throughput of the system can be increased.

As mentioned above, according to some embodiments, the chambers are located on feet 201. The feet can be based on rollers 202. Typically, the rollers are made of hard metal or metal-alloy, e.g. steel. In some embodiments, the rollers of one or several chambers are located on a flat plate 203. Typically, the flat plate is made of hard metal or metal-alloy, e.g. steel. Thereby, the friction between the roll and the flat plate is minimized. Accordingly, the chambers can be moved easily in or against the processing direction. The movement of the chambers can also be done with an electromotor.

In some embodiments, the chambers have at least two pin holes (see, e.g., 204 in FIG. 2) for accommodating pins which assist aligning the first chamber with the second chamber, additionally to the holes for the chamber connecting means and additionally to the chamber connecting means. Typically, the pins are used for determining the relative position of one chamber to the adjacent chamber. In embodiments, the pin holes in the chambers and the pins have such accurate sizes and positions that, when the at least two pins fit into the corresponding pin holes of the adjacent chambers, the adjacent chambers are aligned vertically and horizontally. Thus, according to some embodiments, which can be combined with other embodiments described herein, the pin holes 204 in the chambers and the corresponding pins can be used to control correct alignment of the processing line. This can reduce or eliminate the need for alignment of the chambers, e.g., with laser alignment tools. Further, the pins as an in-situ alignment control allow for fast and easy movement of the chambers along the processing direction, particularly as the pins allow for proper repositioning of the chambers. This makes maintenance during which a seal carrier plate can be replaced even more convenient and effective.

In embodiments, the pin holes and the pins have an ellipsoidal or circular shape. According to some embodiments, the ends of the pin may have a cone like shape to allow for easier insertion in the respective opening in the chamber.

Yet further embodiments, which can be combined with other embodiments described herein, are illustrated with respect to FIG. 4. In some embodiments, the seal carrier plate has at least one additional conduit opening 401. The at least one additional conduit opening can also be sealed with a seal. Therefore, a seal carrying means 402 can be around the at least one additional conduit opening. The seal carrying means around the at least one additional conduit opening can have the same main characteristics than the seal carrying means around the opening 105 for the substrates. Thus, a seal for the conduit opening 401 can be carried by the seal carrier plate and, thereby, the seal for the opening 401 can be inserted and removed between two adjacent chambers together with the seal carrier plate. As an example, the conduit opening can be used for pumping channel. Other uses of the conduit or additional conduits might be provided according to yet further embodiments.

According to yet further embodiments, the seal carrier plate may have at least one protrusion 403 on one edge of the seal carrier plate for pulling out the seal carrier plate from between the chambers. Further additional or alternative modifications of a seal carrier plate may include at least one recess 102 on one edge of the seal carrier plate. Thereby, the recess may be at the opposing end of the seal carrier plate as compared to the protrusion 403.

Typically, each recess is adapted for being positioned on one of the pins used to control alignment between two adjacent chambers. The recess can be adapted for aligning the position of the seal carrier plate during maintenance of the processing line. Thus, when connecting two adjacent chambers, the pin is generally already disposed in the respective openings in the chambers. A small gap of a few centimeters is provided for inserting the seal carrier plate between the chambers. Then, the seal carrier plate can be positioned to be in a supported position wherein the pins are positioned within the recess. This adjustment of the seal carrier plate with respect to the pins and, thus, with respect to the two chambers allows for error free positioning of the seal carrier plate between two adjacent chambers. Further, the gap between the chambers can be closed when the seal carrier plate is secured with the recess on the pin and during moving of the chambers, the seal carried plate position is automatically kept as desired.

While the foregoing is directed to embodiments of the invention, other and further embodiments of the invention may be devised without departing from the basic scope thereof, and the scope thereof is determined by the claims that follow.

## Claims

1. A seal carrier plate (101) adapted for being located between a first chamber (108a) and a second chamber (108b), the seal carrier plate comprising:
a plate shaped member (106) having a first side and a second side;
an opening (105) within the plate shaped member adapted for transferring substrates (303) from the first chamber to the second chamber,
a first seal carrying means (104a) on the first side and a second seal carrying means (104b) on the second side; and
a plurality of holes (103) adapted for having a plurality of fixation elements (107) connecting the first and the second chamber passed therethrough.

2. The seal carrier plate (101) according to claim 1, wherein the opening has a size to allow at least substrates with sizes of 1100 mm * 1250 mm to be transported through the opening from the first to the second chamber.

3. The seal carrier plate according to any of the preceding claims, wherein the first seal carrying means (104a) and the second seal carrying means (104b) are a first groove and a second groove around the opening (105).

4. The seal carrier plate (101) according to claim 3, wherein the first groove surrounds a area having a different size than the area of the second groove, or wherein the first groove and the second groove are offset from each other with respect to the corresponding position on the first side and the second side.

5. The seal carrier plate (101) according to any of the preceding claims, further comprising at least one seal (110a) attached to the first seal carrying means (104a) and at least one seal (110b) attached to the second seal carrying means (104b).

6. The seal carrier plate (101) according to any of the preceding claims, further comprising at least one recess (102) at one edge of the seal carrier plate for aligning the position of the seal carrier plate relative to the first (108a) and second chamber (108b).

7. The seal carrier plate (101) according to any of the preceding claims, further comprising a conduit opening (401) which is sealed outside of the seal carrying means which is around the opening (105) through which the substrates (303) are transferred.

8. A processing line (301) of interchangeable chambers in a processing line comprising a plurality of chambers (108),
the chambers comprising:
at least one opening;
a flange or flanges (109) on at least the side or the sides with the at least one opening;
at least one flat surface (209) at each of the flanges (109),
where in the flanges are adapted for mounting a seal carrier plate (101) between a first chamber (108a) and a second chamber (108b), the seal carrier plate having a flat surface and seal carrying means; and wherein the seal carrier plate is adapted for sealing the first chamber with respect to the second chamber from the environment.

9. The processing line (301) of interchangeable chambers according to claim 8, wherein each chamber (108) comprises at least one pin hole (204), and the system comprises at least one pin between the first chamber and the second chamber, wherein the pin hole is adapted for accommodating the pin for determining the alignment of two adjacent chambers.

10. The processing line (301) of interchangeable chambers in a processing line according to claim 8 or 9, wherein the seal carrier plate (101) is a seal carrier plate according to any of the claims 1-7.

11. Use of a seal carrier plate (101) according to any of the claims 1-7, in between a first chamber (108a) and a second chamber (108b) in a multitude of chambers in a processing line for sealing the first chamber with respect to the second chamber from the environment.

## Amended claims

### Amended claims in accordance with Rule 137(2) EPC.

**1.** A seal carrier plate (101) adapted for being located between a first chamber (108a) and a second chamber (108b), the seal carrier plate comprising:
a plate shaped member (106) having a first side and a second side;
an opening (105) within the plate shaped member adapted for transferring substrates (303) from the first chamber to the second chamber,
a first seal carrying means (104a) on the first side and a second seal carrying means (104b) on the second side, wherein the first seal carrying means (104a) and the second seal carrying means (104b) are a first groove and a second groove around the opening (105); and
a plurality of holes (103) adapted for having a plurality of fixation elements (107) connecting the first and the second chamber passed therethrough,
wherein the first groove surrounds a area having a different size than the area of the second groove, or wherein the first groove and the second groove are offset from each other with respect to the corresponding position on the first side and the second side.

**2.** The seal carrier plate (101) according to claim 1, wherein the opening has a size to allow at least substrates with sizes of 1100 mm * 1250 mm to be transported through the opening from the first to the second chamber.

**3.** The seal carrier plate (101) according to any of the preceding claims, further comprising at least one seal (110a) attached to the first seal carrying means (104a) and at least one seal (110b) attached to the second seal carrying means (104b).

**4.** The seal carrier plate (101) according to any of the preceding claims, further comprising at least one recess (102) at one edge of the seal carrier plate for aligning the position of the seal carrier plate relative to the first (108a) and second chamber (108b).

**5.** The seal carrier plate (101) according to any of the preceding claims, further comprising a conduit opening (401) which is sealed outside of the seal carrying means which is around the opening (105) through which the substrates (303) are transferred.

**6.** A processing line (301) of interchangeable chambers in a processing line comprising a plurality of chambers (108),
the chambers comprising:
at least one opening;
a flange or flanges (109) on at least the side or the sides with the at least one opening;
at least one flat surface (209) at each of the flanges (109),
wherein the flanges are adapted for mounting a seal carrier plate (101) between a first chamber (108a) and a second chamber (108b), the seal carrier plate having a flat surface and seal carrying means; and wherein the seal carrier plate is adapted for sealing the first chamber with respect to the second chamber from the environment,
wherein the seal carrier plate (101) is a seal carrier plate according to any of the claims 1-5.

**7.** The processing line (301) of interchangeable chambers according to claim 8, wherein each chamber (108) comprises at least one pin hole (204), and the system comprises at least one pin between the first chamber and the second chamber, wherein the pin hole is adapted for accommodating the pin for determining the alignment of two adjacent chambers.

**8.** Use of a seal carrier plate (101) according to any of the claims 1-5, in between a first chamber (108a) and a second chamber (108b) in a multitude of chambers in a processing line for sealing the first chamber with respect to the second chamber from the environment.
